# EUROPEAN PATENT APPLICATION

(11) **EP 2 412 686 A2**
(43) Date of publication of application: **01.02.2012**
(21) Application number: 11174138.5
(22) Date of filing: 15.07.2011
(51) Int. Cl.: C03C 17/36, G03F 7/00

(54) **Highly reflective, hardened silica-titania article and method of making**

(30) Priority: 29.07.2010 US 368854 P
(71) Applicant: Corning Inc., Corning, NY 14831 (US)
(72) Inventor: Genier, Michael Lucien, Horseheads, NY 14845 (US)
(74) Representative: Behnisch, Werner

(57) **Abstract**

The present disclosure is directed to improved silica-titania glass articles intended for use in EUV or other high energy reflective optic systems, and to a process for producing such improved silica-titania articles. The improved silica-titania glass articles provide a more stable surface for the coatings that are used in the making of reflective optical elements for EUV applications. The stable surface is provided by densification of at least one face of the silica-titania article, the densification being accomplished by the use accelerated ions, neutrons, electrons and photons (γ-ray, X-ray or DUV lasers). After densification, the densified face of the silica-titania article can be coated with a multilayer reflective coating. The preferred reflective coating is a multilayer Mo/Si coating

## Description

### Cross-reference to Related Applications

This application claims the benefit of priority under 35 U.S.C. § 119 of U.S. Provisional Application Serial No. 61/368854 filed on July 29, 2010 the content of which is relied upon and incorporated herein by reference in its entirety.

### Background

Optical lithography has been has been used for many years to make articles for electronics and has progressed from using common white (visible or VIS) light projection systems to the use of laser-based DUV (deep ultraviolet) stepper systems (operating at ∼ 193nm) for high volume production. Optical lithography is now being extended from the DUV range into the EUV (extreme ultraviolet) range which operate using∼13.4nm (soft x-ray) wavelengths. With each successive generation of optical lithography systems, the optical materials used to reflect, refract, and generally manipulate the light with which they interact have had to undergo significant development to meet ever increasing technical demands as the wavelength of light being used has decreased. These demands include improved materials which provide for higher transmission, better optical uniformity, low stress and/or provide more laser durability over for a long lifetime of the tools that use these materials since such tools have become increasing expensive. The goal of the changing lithography systems (VIS to DUV to EUV) is to produce highly accurate and much reduced copies of the master patterns which are needed to create the increasing demand for higher speed and smaller dimensioned semiconductor devices. Presently, production systems are being made that use DUV wavelengths of∼193nm which can achieve half-pitch line widths as small as ∼322nm. Under development are next generation EUV systems that show significant advances in increasing speed and reducing size. These EUV systems will use highly energetic EUV radiation at 13.4nm. The EUV systems will strain the existing materials and hence there is a need for new or improved materials that can meet the needs of EUV lithography

### Summary

The present disclosure is directed to improved silica-titania (SiO₂-TiO₂, also called titania-doped silica) glass articles intended for use in EUV or other high energy reflective optic systems, and to a process for producing such improved silica-titania articles. The improved silica-titania glass articles provide a more stable surface for the coatings that are used in the making of reflective optical elements for EUV applications. In one aspect the disclosure is directed to an improved base glass consisting of silica-titania glass that has been densified. In another aspect the disclosure is directed to improved articles consisting of an improved silica-titania base glass having a multilayer reflective optical coating suitable for EUV application deposited on the base glass that has been densified. Densification can be done using accelerated ions, neutrons, electrons and photons (γ-ray, X-ray or DUV lasers).

The improved silica-titania base glass is glass that, prior to deposition of the coating materials, has been deliberately irradiated for a selected time with radiation having a wavelength of <250nm. The irradiation of the silica-titania glass induces compaction or densification of the at least the surface layer of the surface of the glass to which the reflective optical coating(s) are applied. The result of this improvement to silica-titania glass is a radiation hardened, silica-titania base glass, and articles formed using such glass, that provide the beneficial bulk properties of the base silica-titania glass (CTE control, beneficial expansivity), along with an improved surface stability that enhances its use in short wavelength reflective optic application.

The disclosure is also directed to a reflective optic for use in EUV lithography, said optic consisting of a silica-titania glass substrate having at least one face that has been radiation hardened and a selected multilayer reflective coating on the hardened face. In one embodiment the multilayer reflective coating is a metal silicide (M/Si, where M is a selected metal), for example without limitation, Mo/Si, multilayer coating. In another embodiment the silica-titania glass consists of 3-12 wt% titania and 88-97 wt% silica. In a further embodiment the reflective coating consists 30-60 coating periods, each period having one metal layer and one silicon layer, the metal layer being the first layer on top of the radiation hardened face of the substrate, and the metal and Si layers in a period each, independently, have a thickness in the range of approximately 2nm to approximately 5nm per layer.

The disclosure is further directed to a glass article for use with high energy, <50nm wavelength optical systems, the glass article having at least one surface densified to a selected depth. In one embodiment the glass article is used as a reflective optical element, within said high energy optical system. In another embodiment the glass article is used as a mechanical/structural support within said high energy optical system.

The disclosure is additionally directed to an EUV optical system, the system containing at least one optical element having at least one face that has been radiation hardened and a selected multilayer reflective coating on the hardened face. In one embodiment the selected reflective coating consists 30-60 coating periods, each period having one Mo layer and one Si layer, the Mo layer being the first layer on top of the radiation hardened face of the substrate followed by the Si layer. The order is repeated in each period: first the Mo layer and then the Si Layer.

The disclosure is further directed to a reflective optic for use in EUV lithography, the optic consisting of a silica-titania glass substrate having at least one face hat has been radiation hardened face and a selected multilayer reflective coating on the hardened face of said substrate; wherein:
the silica-titania glass consists of 3-12 wt% titania and 88-97 wt% silica,
the multilayer reflective coating is a Mo/Si multilayer coating consisting 30-60 coating periods, each period having one Mo layer and one Si layer, the Mo layer being the first layer on top of the radiation hardened face of the substrate, and
the Mo and Si layers in a period each, independently, have a thickness in the range of approximately 2nm to approximately 5nm per layer.

### Brief Description of the Drawings

Figure 1 is an illustration of an of a multilayer coated glass substrate having a localized damage zone caused by high intensity radiation that result in surface changes.

Figure 2 is an illustration of a glass substrate having a compacted/densified zone on the surface of a glass substrate and a multilayer coating that provides resistance to damage from high intensity radiation that is placed on top of the compacted/densified zone.

### Detailed Description

The lithography industry's ongoing shift toward the 13.4nm EUV wavelength radiation has brought significant challenges to many aspects of the EUV systems design. Among these are the creation and management of the source light, the design of systems to operate in a controlled environment chamber, optical design, and the need for unique low expansion materials to be used for all structural parts of the system, including the optical materials as well as coatings used to manipulate the EUV radiation. Further, while past lithography systems have typically been at least partially refractive in nature (some reflective elements and some wavelength transmitting elements), EUV systems are designed as completely reflective optical systems based on use of reflective multilayered metal silicide coatings applied to a base substrate, metal silicides being binary compounds of silicon, Si, and another metal that is usually a more electropositive metal, for example Mo. Mo/Si coatings are preferred are preferred. Other reflective coatings are known and can also be used in practicing this disclosure, for example, W/Si and Ni/Si. In such a reflective system design, the optical materials that are used as the base materials for the coating must be extremely stable over a wide temperature range of use in order to provide the precise control needed to achieve the lithographic printing of the desired, very small size in the range of 9-40nm. The present base materials used as substrates do not meet this requirement. Consequently, improved materials are needed.

The present disclosure is directed to optical elements for use in EUV lithography. The elements consist a base material or substrate having at least one face at which the base materials has been densified for a selected depth or distance into the substrate to form a densified substrate layer and a multilayer coating, for example, a reflective coating, over the densified layer. A multilayer metal silicide coating consisting of a plurality alternating layers of a selected metal and silicon, for example, Mo and Si (a Mo/Si coating) is used herein as an exemplary multilayer coating. Other coating include W/Si and Ni/Si In accordance with the disclosure, the base glass upon which the metal silicide coating is deposited is deposited is a silica-titania glass having at least one face that has been densified by being subjected radiation below 250nm wavelength. In one embodiment the radiation is less than 193nm wavelength. In another embodiment the radiation is less than 50nm wavelength.

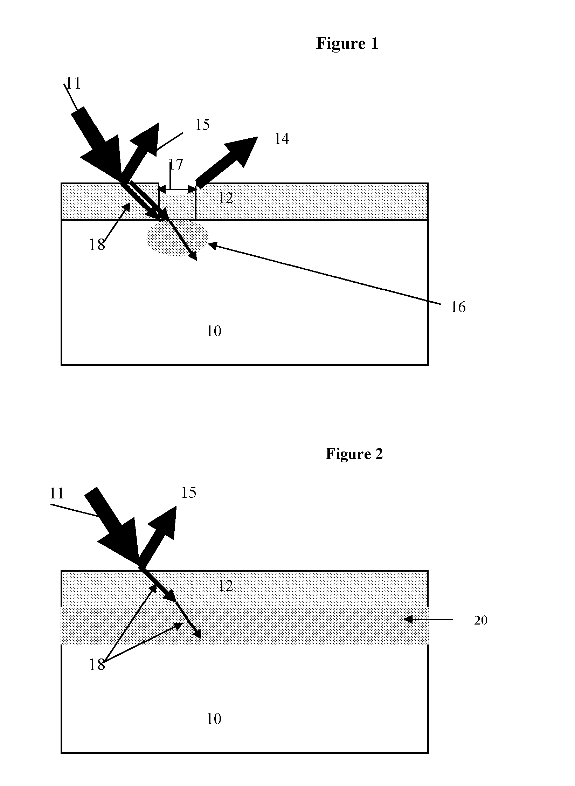

Figure 1 is an illustration of a glass substrate 10 with a multilayer coating 12 thereon having a localized damage zone 16 in the glass that is caused by incident high intensity radiation 11 that passes through the multilayer coating 12 as exemplified by numeral 18 into glass 10 to cause surface changes 17 in multilayer coating 12. In Figure 1 numeral 11 represents light that is properly reflected from coating 12 and numeral 14 represents light that is misdirected as a result of the coating 12 surface change 17.

Figure 2 is an illustration of a glass substrate 10 having a compacted/densified zone 20 between a glass substrate 10 and a multilayer coating 12 that provides resistance to damage from high intensity radiation 11 that passes through the multilayer coating as exemplified by numeral 18. As a result of the densified layer 20, which is formed by irradiation of the surface of the glass 10 prior to deposition of multilayer coating 12, the surface of glass 10 is resistance to damage during the use of the coated element in EUV lithography. As a result of the resistance of the glass 10 densified damage by radiation during lithographic usage, changes in the surface of the multilayer coating are avoided or minimized.

Silica-titania glasses have been known in the art for some decades and the glasses can be made by a number of means using silica and titania precursors, for example, flame hydrolysis, the combustion of silica and titania precursors in OVD, VAD and plasma deposition processes, and sol-gel processes. These processes are used to create a dense, glassy silica-titania material containing between 3 and 18 wt% titania, the remainder of the glass being silica, In one embodiment the titania content is in the range of 3-12 wt%, the remainder of the glass being silica. In a further embodiment the titania content is in the range of 5-9 wt%, the remainder of the glass being silica. The addition of the titania to the base silica material results in the flattening and/or shifting of the silica base material's CTE, expansivity, and other physical and optical properties. Most of this early work was done by M.E. Nordberg, P. Schultz and others (see U.S. Patent Nos. 2,326,059 and 3,690,855, and "Binary Titania-Silica Glasses Containing 10-20 Wt% TiO2," J. Amer. Ceram. Soc. Vol. 59, Issue 5-6, pages 214-219). More recent patents describing silica-titania glass and methods of making it include U.S. Patent Nos. 5,154,744, 5,970,757 and 7,155,936, and European patent Nos. 1 608 598 and 1 608 599. all of whose teachings are incorporated herein by reference. For many years, the basic low CTE silica-titania glass has been successfully used in ground based astronomical application, in space borne telescopes, in applications where mechanical stability was needed, and, recently, it has become the material of choice for masks and optics in EUV lithography systems. In EUV systems the silica-titania glass provided a combination of characteristics which help make the EUV lithography system perform its goal of printing the small features (∼32nm and below). Silica-titania glasses have a further advantage in that they can be modified both compositionally and thermally to essentially tailor the CTE and desired zero cross over temperature to the values desired in this particular application. [See U.S. RE40586E1 and U.S. Application Publication No. 2009/0143213A1, whose teachings are incorporated herein by reference.] Using these patents one can make boules of glass having a diameter in of 10cm to 200cm and thickness in the range of 2cm to 30cm. One can also make a rod of glass attached to a bait that can be slumped and formed into the desired shape which can subsequently be radiation hardened as described herein.

While the present thermally stable silica-titania materials are accepted and used in the EUV stepper's designs, the silica-titania glass materials can be changed after exposure to radiation, particularly when the radiation is below 250 nm, of high fluence (intensity) and of long duration. This phenomenon of radiation damage is discussed in relation to pure silica glasses in a number of including U.S. Patent Nos. 5,267,343, 5,574,820, 6,705,125 and 6,920,765. The exposure power produced by the light source over time indicates the dose of energy the silica glass material is exposed to. In materials that are transmitting, the energy is often passed through the optical material, with residual effects as noted in the above references, and the residual effects affect the use of the optical material in the less than 250nm transmitting optical systems through increased absorption over time, induced birefringence effects, and the activation and creation of various other known silica lattice defects (e.g. E' SIH, and Si-Si metal-metal bonds). Radiation induced compaction in silica-titania has been discussed by M. Rajaram et al., "Radiation-Induced Surface Deformation in Low-Thermal-Expansion Glasses and Glass-Ceramics," Advanced Ceramic Materials, Vol. 3 [6], 598-600 (1988).

These defects mentioned above occur in the optical materials (that is, materials that are transmissive) exposed to the intense energy of a low wavelength radiation source, for example, a wavelength of less than 250nm. However, EUV lithographic systems are reflective systems and not transmissive systems. The reflective nature of the EUV components is the result of utilizing a multilayer coating of a selected metal and silicon to form a thin film coating stack. At the present time the preferred multilayer reflective coatings are made by alternating layers of molybdenum and silicon to produce Mo/Si multi layered surfaces which reflect the EUV (13.4nm) light. While many other metal-silicon coating combinations have been evaluated with the goal of improving reflectivity in the 13.4nm wavelength region, the Mo/Si multilayer coating remains the preferred coating.

In any basic optics text, most studies of reflectivity deal with the idea "perfect" reflector. The use of a "perfect" model is helpful for elementary discussions and eases solving technical problem through the use of a 1:1 relationship between Iᵢₙ and Iₒᵤₜ. However, perfect reflectors do not exist and all reflectors have imperfections. In each case, there is an amount of light lost (approximately 4-7%) from the interaction of the incoming light with the reflecting media at each interface. Some light is scattered in nontarget directions, adding to the stray light in the system, while some light is absorbed and/or transmitted through the reflective coatings. The light leakage through the "imperfect" reflective coatings has the significant potential of damaging the surface of silica-titania substrate underlying a reflective coating regardless of whether the coated part is an optic or a mask. The result is that damage to the underlying substrate will increase over time and exposure dose for a significant period of the optics life. For example, if the radiation leaks through the coating to surface of the substrate, the result is that the surface of the optical element can be densified which in turn can lead to warpage due to small expansion differences between adjacent areas of the substrate's surface and the underlying bulk of the substrate that is not densified.

The issue of improved reflectivity and increasing availability of higher power source light is actually quite critical to the design and efficient use of the EUV systems. The systems have typically 6-8 reflective surfaces, which ultimately create the reduced lithographic patterns. The EUV optical systems and source designers have been working diligently to address this problem from multiple angles. There have been efforts to increase the source power of the EUV light source, which links directly to system throughput in terms of wafers per hour, (based on the resist sensitivity). This has a significant effect on the cost of ownership and the entire business model for EUV lithography, but is also increases the amount of light energy seen and processed by the optical elements used in the system be they reflective or transmissive. To meet the business criteria for higher production rates, power levels have or are projected to increase from the present 40-90W level to the 100W level in the near future in order to meet the acceptable production rates, and the power levers are projected to increase over the longer term to approximately 500W. As a result of the focus on productivity, makers of the light source will have to extend the power range, with a projected need to increase the power level by a factor of at least 2X over the 100W near term target. Consequently, with each increase in power, the silica-titania optical materials will be exposed to higher energy densities that in turn will produce more stress on the optical coating (which is likely to result in more light leakage) and the underlying silica-titania optical substrate. While silica-titania glasses have been used for many years in astronomical mirror optics, this use relied upon the critical CTE characteristics, and the silica-titania astronomical mirror elements have typically been used for image capture in the infrared through the visible portion of the electromagnetic spectrum. The unintentional exposure of such optics to damaging radiation in space (for example, gamma or x-rays) would very likely not be detectible in the optic systems because the changes are so subtle that they are lost in the noise of the longer wavelength infrared and visible light images.

Silica-titania does not possess the same level of transmission as a typical pure silica glass which can have transmissions in the range of 99.4%/cm to 99.9%/cm in the 193nm wavelength range. For silica-titania glass the transmission is lower, typically being <50% transmittance in the 193nm wavelength range. The result is that silica-titania glass is more prone to absorbing any EUV light that leaks through the coating, with the result that the silica-titania glass is more like to be damaged than is a pure silica glass. The damage can result in a number of effects that are due to physical changes to the underlying base silica-titania glass material. The initial system defects would likely manifest themselves as optical aberrations or focus changes, which would necessitate the costly rebuild/replacement defective optics to bring the system back into service.

Thus, in one embodiment this disclosure is directed to a silica-titania glass substrate having a stable, radiation hardened surface suitable for use in EUV lithography. The glass can be used as a reflective optic or as a non-transmissive article such as a structural member within the UV system with potential exposure to stray EUV radiation in the lithography tool. When used as a reflective optic the silica-titania glass substrate has a selected multilayer reflective coating on the hardened surface. In one embodiment the multilayer reflective coating as a Mo/Si coating consisting 60 coating periods where each period consists of one Mo layer and one Si layer, the Mo layer being the first layer of each to be applied. This order, Mo layer than Si layer, is repeated in each period. The Mo and Si layers each have a thickness ranging from approximate 2nm to approximately 5nm per layer.

In another embodiment this disclosure is directed to a method of making a silica-titania glass having at least one face that has been radiation hardened. The method comprises the steps of:
manufacturing a boule of silica-titania glass using a method selected from the group consisting of flame hydrolysis, OVD, CVD and plasma, all of which use a silica precursor material and a titania precursor material that is converted, in the present of oxygen and a fuel (for example, hydrogen, methane, natural gas, ethane, etc.) to a silica-titania soot that is gathered or deposited in a vessel or on a surface (a bait or mandrel) that is consolidated into a silica-titania glass:
   consolidating the silica-titania soot by depositing the soot into a vessel or on a bait at consolidation or by heating the soot or a preform formed from the soot to consolidation temperatures after the soot has been collected;
   annealing the consolidated silica-titania glass according to a selected annealing schedule;
   directly forming the consolidated silica-titania glass into a blank (generally used for smaller boules such as those that are less than 0.2 meter in diameter and less 0.15 meter in thickness, or, if the consolidated glass is a large boule, for example, 0.2-2 meter in diameter and extracting a glass blank from the boule using water jet, wire sawing and mechanical cutting techniques;
   grinding lapping and polishing the blank to mechanical and optical specifications, such process including, as necessary, mechanical polishing, ion beam polishing or milling, chemical polishing and magnetorheological finishing to form an optic;
   densifying at least one face of the optic by exposing said face to incident high energy radiation of wavelength less than 250nm for a selected time in order to induce compaction (densification) of said face to a selected depth into the optic; and
   analyzing the optic after irradiation to determine that the radiation hardened face of the optic is in conformance with the specification and, if required, re-polishing the radiation hardened face to meet specification without removal of the entire densified layer.
In one or an additional number of steps a multilayer reflective coating is deposited on the radiation hardened face. The foregoing method is suitable for producing a silica-titania glass consisting essentially of 3-12 wt% titania and 88-97 wt% silica.

In one embodiment the deposited multilayer reflective coating is a Mo/Si coating consists of 30-60 periods, each period consisting of one Mo layer and one Si layer deposited on the radiation hardened face, the Mo layer being the first layer deposited. Each of the Mo and Si layer is deposited to a thickness in the range of 2-5nm using methods known in the art, for example without limitation, magnetron sputtering, chemical vapor deposition, ion assisted deposition and plasma ion assisted deposition. Methods of making silica-titania glass boules are disclosed in a number of patent, patent applications and technical articles including U.S. Patent Nos. 2,326059, 5,154,744, 5,970,757, 7,155,936, and reissue No. RE40586E1, U.S. Application Publication No. 2009/0143213A1, and European patent Nos. 1 608 598 and 1 608 599.

It will be apparent to those skilled in the art that various modifications and variations can be made to the embodiments described herein without departing from the spirit and scope of the claimed subject matter. Thus it is intended that the specification cover the modifications and variations of the various embodiments described herein provided such modification and variations come within the scope of the appended claims and their equivalents.

## Claims

1. A reflective optic for use in EUV lithography, said optic consisting of a silica-titania glass substrate having at least one face that has been radiation hardened and a selected multilayer reflective coating on the hardened face;
wherein the multilayer reflective coating is a metal silicide multilayer coating and wherein the silica-titania glass consists of 3-12 wt% titania and 88-97 wt% silica.

2. The reflective optic according to claim 1, wherein the reflective coating consists 30-60 coating periods, each period having one metal layer and one silicon layer, the metal layer being the first layer on top of the radiation hardened face of the substrate.

3. The reflective coating according to claim 2, therein the metal and Si layers in a period each have a thickness in the range of approximately 2nm to approximately 5nm per layer.

4. The reflective optic according to claim 1, wherein the metal is Mo and the reflective coating consists 30-60 coating periods, each period having one Mo layer and one Si layer, the Mo layer being the first layer on top of the radiation hardened face of the substrate, and the metal is molybdenum; and
the Mo and Si layers in a period each have a thickness in the range of approximately 2nm to approximately 5nm per layer.

5. The reflective optic according the claim 1, wherein the silica-titania glass consists of 5-9 wt% titania and 91-95 wt% silica, and
the reflective coating consists 30-60 coating periods, each period having one Mo layer and one Si layer, the Mo layer being the first layer on top of the radiation hardened face of the substrate, and
the Mo and Si layers in a period each have a thickness in the range of approximately 2nm to approximately 5nm per layer.

6. A method for making a reflective optic for use in EUV lithography, said method comprising:
providing a silica-titania glass blank consisting of 3-12 wt% titania and 88-97 wt% silica;
grinding lapping and polishing the blank to mechanical and optical specifications to form a silica-titania glass optic;
densifying at least one face of the optic by exposing said face to incident high energy radiation of wavelength less than 250nm for a selected time in order to induce densification of said face to a selected depth into the optic to thereby form an optic having at least one radiation hardened face;
analyzing the optic after irradiation to determine that the radiation hardened face of the optic is in conformance with the specification and, if required, re-polishing the radiation hardened face to meet specification without removal of the entire densified layer; and
depositing a multilayer reflective coating on said radiation hardened face to thereby form a reflective surface suitable for EUV lithography.

7. The method according to claim 6, wherein depositing a multilayer reflective coating means depositing metal/Si coating having of 30-60 periods in which each period consists of one metal layer and one Si layer deposited on the radiation hardened face, the metal layer being the first layer deposited, and each of the metal layer and Si layer being deposited to a thickness in the range of 2-5nm.

8. The method according to claim 7, wherein metal is molybdenum and the deposited multilayer reflective coating is a Mo/Si coating.

9. The method according to claim 7, wherein the deposition of the multilayer Mo/Si is by a deposition method selected from the group consisting of magnetron sputtering, chemical vapor deposition, ion assisted deposition and plasma ion assisted deposition.

10. A method for making a radiation hardened silica-titania glass, said method comprising:
manufacturing a boule of silica-titania glass using a method selected from the group consisting of flame hydrolysis, OVD, CVD and plasma, said selected method using a silica precursor material and a titania precursor material that is converted, in the present of oxygen and a fuel, to a silica-titania soot that is deposited in a vessel or on a surface;
consolidating the silica-titania soot at consolidation temperatures;
annealing the consolidated silica-titania glass according to a selected annealing schedule;
forming a silica-titania blank from said boule;
grinding lapping and polishing the blank to form a silica-titania optic;
densifying at least one face of the optic by exposing said face to incident high energy radiation of wavelength less than 250nm for a selected time in order to induce compaction (densification) of said face to a selected depth into the optic; and
analyzing the optic after irradiation to determine that the radiation hardened face of the optic is in conformance with the specification and, if required, re-polishing the radiation hardened face to meet specification without removal of the entire densified layer;
wherein said silica-titania glass consists of 3-12 wt% titania and 88-97 wt% silica.
